(19) Europäisches Patentamt
European Patent Office
Office européen des brevets

(11) **EP 4 483 142 B1**

(12) **EUROPÄISCHE PATENTSCHRIFT**

(45) Veröffentlichungstag und Bekanntmachung des Hinweises auf die Patenterteilung:
**11.03.2026 Patentblatt 2026/11**

(21) Anmeldenummer: **23702575.4**

(22) Anmeldetag: **30.01.2023**

(51) Internationale Patentklassifikation (IPC):
**G01D 5/20** (2006.01)    **G01D 3/036** (2006.01)
**G01R 27/26** (2006.01)

(52) Gemeinsame Patentklassifikation (CPC):
**G01D 3/036; G01D 5/2006; G01R 27/2611**

(86) Internationale Anmeldenummer:
**PCT/EP2023/052157**

(87) Internationale Veröffentlichungsnummer:
**WO 2023/160950 (31.08.2023 Gazette 2023/35)**

(54) **VERFAHREN UND SCHALTUNGSANORDNUNG ZUR ERMITTLUNG EINER INDUKTIVITÄT EINER MESSSPULE**

METHOD AND CIRCUIT DEVICE FOR THE DETERMINATION OF THE INDUCTIVITY OF A MEASURING COIL

PROCÉDÉ ET DISPOSITIF DE CIRCUIT POUR LA DÉTERMINATION DE L'INDUCTIVITÉ D'UNE BOBINE DE MESURE

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorität: **24.02.2022 DE 102022201923**

(43) Veröffentlichungstag der Anmeldung:
**01.01.2025 Patentblatt 2025/01**

(73) Patentinhaber: **Schaeffler Technologies AG & Co. KG**
**91074 Herzogenaurach (DE)**

(72) Erfinder:
• WIESE, Peter
  80687 München (DE)
• KÖHLER, Stefan
  80687 München (DE)

(74) Vertreter: **Schaeffler Technologies**
**Industriestraße 1-3**
**91074 Herzogenaurach (DE)**

(56) Entgegenhaltungen:
DE-A1- 4 142 680    DE-A1- 4 304 060
US-A- 5 043 661    US-A1- 2019 094 046

EP 4 483 142 B1

**Beschreibung**

Die vorliegende Erfindung betrifft ein Verfahren und eine Schaltungsanordnung zur Ermittlung einer Induktivität einer Messspule. Ferner betrifft die Erfindung eine Verwendung eines derartigen Verfahrens bzw. einer derartigen Schaltungsanordnung.

Aus dem Stand der Technik sind derartige Verfahren und Schaltungsanordnungen in vielfältigen Ausführungen beispielsweise zur Ermittlung der Induktivität einer Messspule eines Positionssensors oder eines Winkelsensors bekannt.

Zumeist beruht die Ermittlung der Induktivität darauf, dass die Messspule als eine elektrische Komponente derart in eine Kippschaltung (z.B. Mono-Flop) oder eine Oszillationsschaltung eingebunden wird, dass deren Induktivität eine Zeitkonstante bzw. Pulsdauer oder Frequenz eines von der Schaltung erzeugten Signals definiert. Durch eine geeignete Auswertung dieses Messsignals kann die Induktivität ermittelt werden.

Insbesondere bei einer aus metallischem Material (z.B. Kupfermaterial) gebildeten Messspule ergibt sich das Problem, dass das Messignal bzw. z.B. eine daraus ermittelte Zeitkonstante nicht nur von der Induktivität sondern auch von einem ohmschen Widerstandsanteil der Impedanz der Messspule abhängt und dieser Widerstandsanteil oftmals stark temperaturabhängig ist. Die Temperaturabhängigkeit des Widerstandswerts führt bei Anwendung des Verfahrens in Umgebungen mit schwankender Temperatur zu entsprechenden Messfehlern bei der Ermittlung der Induktivität.

Aus der DE 41 20 861 C2 ist eine Stellweg-Messeinrichtung zur Messung von zwei Winkeln bekannt, wobei für jede dieser Winkelmessungen die Induktivität einer jeweiligen Messspule ermittelt wird. Um hierbei eine Temperaturabhängigkeit des Ermittlungsergebnisses zu vermeiden (Temperaturkompensation), umfasst diese bekannte Messeinrichtung ferner eine Referenzspule und wird ein Verhältnis zwischen den Induktivitäten der beiden, den gleichen Umgebungseinflüssen ausgesetzten Spulen (Messspule und Referenzspule) ermittelt.

Aus der DE 43 04 061 B4 ist eine Schaltungsanordnung zur Auswertung von Messreaktanzen bekannt, bei welcher für eine temperaturkompensierte Ermittlung einer Induktivität einer Messspule ebenfalls eine den gleichen Umgebungseinflüssen ausgesetzte Referenzspule verwendet wird.

Nachteiligerweise beansprucht eine Referenzspule jedoch zusätzlichen Bauraum, erzeugt zusätzliches Gewicht und erfordert zusätzliche elektrische Leitungen und Kontaktierungen. Außerdem entstehen höhere Kosten.

In Bezug auf die zu kompensierende Temperaturdrift des ohmschen Widerstandsanteils der Messspule kommt hinzu, dass aufgrund von Fertigungsstreuungen eine Referenzspule zumeist nicht den exakt gleichen Widerstandswert bzw. die gleiche Temperaturdrift besitzt wie die eigentliche Messspule, was zu Messfehlern führen kann.

Ein anderer Lösungsansatz für die Temperaturkompensation besteht darin, die Temperatur der Messspule mittels eines separaten Temperatursensors zu erfassen und basierend auf der erfassten Temperatur eine erfasste Induktivität zu korrigieren.

Bei einer Temperaturerfassung mittels eines Temperatursensors ergibt sich abgesehen von den damit verbundenen zusätzlichen Kosten z.B. das Problem, bei raschen Temperaturänderungen einen ausreichenden Gleichlauf zwischen der vom Sensor gemessenen Temperatur und der Temperatur der Messspule sicherzustellen. Da dies in der Praxis oftmals nur unzureichend gelingt, bringt auch diese Art der Temperaturkompensation Messfehler mit sich.

Ferner ist aus der DE 42 04 060 A1 ein Verfahren zur Regelung des Drucks in Behältern, insbesondere in Dosier- und Niederdrucköfen sowie Metallpumpen, bekannt, bei dem der Druck im Ofeninnenraum erfasstt und über einen Regelkreis geregelt wird. Dabei wird eine Druck-Kaskadenregelung durchgeführt wird, wobei der Druck-Istwert im und der Druck-Sollwert für den Behälterinnenraum einem ersten aufweisenden Regelkreis zugeführt und die sich ergebende Stellgröße mit dem Druck-Sollwert addiert wird und das Ergebnis als Führungsgröße für einen ein Proportionalventil aufweisenden zweiten Regelkreis zugeführt wird.

Es ist eine Aufgabe der vorliegenden Erfindung, einen neuartigen Weg aufzuzeigen, mit dem unter Vermeidung der vorstehend erläuterten Nachteile des Stands der Technik eine temperaturkompensierte Ermittlung der Induktivität einer Messspule ermöglicht wird.

Gemäß eines ersten Aspekts der vorliegenden Erfindung wird diese Aufgabe durch ein Verfahren zur Ermittlung einer Induktivität einer Messspule gelöst, umfassend die Schritte:

- Einschalten und Ausschalten eines durch die Messspule fließenden Spulenstroms zu Einschaltzeitpunkten und Ausschaltzeitpunkten, die mit Hilfe eines Taktsignals vorgegeben werden,

- Erzeugen eines PWM-Signals mit einem für die Induktivität der Messspule repräsentativen Tastverhältnis, indem das PWM-Signal mit steigenden und fallenden PWM-Signalflanken erzeugt wird,

- die einerseits zeitgleich mit dem Einschalten oder mit dem Ausschalten des Spulenstroms getriggert werden und andererseits getriggert werden, sobald ein Wert des Spulenstroms eine vorgegebene Triggerschwelle erreicht, oder

- die beide jeweils getriggert werden, sobald ein Wert des Spulenstroms eine vorgegebene Triggerschwelle erreicht,

- Auswerten des PWM-Signals, um dessen Tastverhältnis und daraus die Induktivität der Messspule zu ermitteln,

wobei das Verfahren für eine Kompensation einer Temperaturabhängigkeit des Tastverhältnisses des PWM-Signals aufgrund einer Temperaturabhängigkeit eines ohmschen Widerstands der Messspule ferner die Schritte umfasst:

- Erfassen eines stationären maximalen Werts des Spulenstroms nach einem Einschalten und vor dem nachfolgenden Ausschalten des Spulenstroms,

- Vorgeben der Triggerschwelle in Abhängigkeit von dem erfassten stationären maximalen Wert des Spulenstroms.

Die Grundidee der Erfindung besteht darin, eine Temperaturabhängigkeit des ohmschen Widerstandanteils der Messspule auszunutzen, um die Messspule selbst gewissermaßen als einen Temperatursensor zu verwenden.

Vorteilhafterweise sind hierbei die Art und Weise der Induktivitätsermittlung und die Bewerkstelligung der Temperaturkompensation in synergistischer Weise miteinander verknüpft.

Durch die Erfindung wird vorteilhaft eine zusätzliche Referenzspule ebenso wie ein zusätzlicher Temperatursensor entbehrlich. Daher kann mit der Erfindung Bauraum und Gewicht eingespart werden. Zudem ergibt sich vorteilhaft eine für viele Anwendungsfälle bedeutsame Vereinfachung hinsichtlich der elektrischen Leitungen und Kontaktierungen zwischen der Messspule und einer zur Ermittlung der Induktivität vorgesehenen Schaltungsanordnung.

Eine solche Schaltungsanordnung kann z.B. in einer separaten, d.h. entfernt von der Messspule angeordneten Steuereinrichtung (z.B. Steuergerät) enthalten und in diesem Fall z.B. mit der Messspule "verkabelt" sein.

Alternativ kann eine solche Steuereinrichtung bzw. Schaltungsanordnung baulich mit der Messspule zusammengefasst ausgebildet sein, z.B. zusammen mit der Messspule auf einer gemeinsamen Schaltungsträgerplatte angeordnet.

Für die Ermittlung der Induktivität wesentlich ist das vorerwähnte Erzeugen eines PWM-Signals mit einem für die Induktivität der Messspule repräsentativen Tastverhältnis. Durch ein geeignetes Auswerten des PWM-Signals bzw. dessen Tastverhältnisses lässt sich somit die Induktivität der Messspule ermitteln.

In einer Ausführungsvariante umfasst die Auswertung des PWM-Signals eine Tiefpassfilterung, um damit ein für das Tastverhältnis bzw. somit die Induktivität repräsentatives Signal (z.B. Spannungssignal) zu erhalten. Falls gewünscht kann letzteres Signal z.B. einer Analog/Digital-Wandlung (und ggf. einer digitalen Weiterverarbeitung) unterzogen werden, um als Ergebnis der Auswertung alternativ oder zusätzlich zu einem analogen Signal auch ein für die Induktivität (bzw. eine Messgröße im Falle eines induktiven Sensors) repräsentatives digitales Signal (Datensignal) zu erhalten.

In einer Ausführungsvariante erfolgt das Auswerten des PWM-Signals mittels digitaler Signalverarbeitung. Beispielsweise können die zur Induktivitätsermittlung relevanten Zeitdauern von Pulsen und/oder Pausen des PWM-Signals "ausgezählt" werden (vgl. z.B. DE 41 20 861 C2), um das Tastverhältnis bzw. somit die Induktivität der Messspule zu ermitteln. Basierend auf dem Ergebnis einer solchen digitalen Auszählung kann sodann auf digitaler Ebene ein für die Induktivität (bzw. Messgröße eines Sensors) repräsentatives digitales Signal (Datensignal) erzeugt werden.

Auch könnte das PWM-Signal zwecks digitaler Auswertung z.B. als solches einer Analog/Digital-Wandlung unterzogen werden, um nachfolgend das Tastverhältnis und somit die Induktivität bzw. Messgröße des Sensors unter Verwendung von digitaler Signalverarbeitung zu ermitteln.

In allen derartigen Varianten kann z.B. vorgesehen sein, die digitalen Schritte der Auswertung mittels einer programmgesteuerten Rechnereinrichtung wie z.B. in einem Mikrocontroller oder dergleichen durchzuführen. Alternativ oder zusätzlich kommt im Rahmen der Auswertung z.B. auch der Einsatz einer anwendungsspezifisch integrierten Schaltung (ASIC) oder dergleichen in Betracht.

Bei dem Taktsignal kann es sich insbesondere z.B. um ein periodisches Rechtecksignal handeln.

Für das "Einschalten" und "Ausschalten" der Spulenbestromung kann vorgesehen sein, dass an die Messspule bzw. an einen die Messspule beinhaltenden Strompfad wechselweise eine vorbestimmte Spannung (z.B. eine Versorgungsspannung der verwendeten Schaltungsanordnung) und eine Spannung von Null angelegt wird.

Alternativ kann für das "Einschalten" und "Ausschalten" der Spulenbestromung vorgesehen sein, dass an die Messspule bzw. den Strompfad wechselweise eine vorbestimmte erste Spannung und eine davon verschiedene vorbestimmte zweite Spannung angelegt wird, die beide ungleich Null sind.

Die Einschaltzeitpunkte und Ausschaltzeitpunkte der Spulenbestromung können z.B. zeitgleich zu Taktsignalflanken vorgesehen sein, wofür die betreffenden Schaltvorgänge z.B. durch jeweilige Taktsignalflanken getriggert werden können. Die Frequenz des Taktsignals kann hierbei der Frequenz der Einschaltvorgänge (bzw. Ausschaltvorgänge) der Spulenbestromung entsprechen, oder aber z.B. als ein Vielfaches davon darstellen, wobei in letzterem Fall die Einschaltvorgänge (bzw. Ausschaltvorgänge) dann durch die Flanken einer entsprechend frequenzgeteilten Version des Taktsignals getriggert werden können.

Das PWM-Signal kann z.B. mit PWM-Signalflanken erzeugt werden, die einerseits (z.B. steigende oder fallende PWM-Signalflanken) zeitgleich mit dem Einschalten des Spulenstroms getriggert werden und andererseits (z.B. fallende bzw. steigende PWM-Signalflanken) getriggert werden, sobald ein Wert des infolge der eingeschalteten Bestromung steigenden Spulenstroms eine vorgegebene Triggerschwelle überschreitet.

Alternativ kann das PWM-Signal z.B. mit PWM-Signalflanken erzeugt werden, die einerseits (z.B. steigende oder fallende PWM-Signalflanken) zeitgleich mit dem Ausschalten des Spulenstroms getriggert werden und andererseits (z.B. fallende bzw. steigende PWM-Signalflanken) getriggert werden, sobald ein Wert des infolge der ausgeschalteten Bestromung sinkenden Spulenstroms eine vorgegebene Triggerschwelle unterschreitet.

Alternativ kann das PWM-Signal z.B. mit steigenden und fallenden PWM-Signalflanken erzeugt werden, die einerseits (z.B. steigende oder fallende PWM-Signalflanken) getriggert werden, sobald ein Wert des infolge der eingeschalteten Bestromung steigenden Spulenstroms eine vorgegebene Triggerschwelle überschreitet, und andererseits (z.B. fallende bzw. steigende PWM-Signalflanken) getriggert werden, sobald ein Wert des infolge der ausgeschalteten Bestromung sinkenden Spulenstroms eine vorgegebene Triggerschwelle unterschreitet.

In allen drei Fällen kann das PWM-Signal mit einer konstanten Periodendauer, jedoch mit von der Induktivität der Messspule abhängigem Tastverhältnis erzeugt werden.

Das Ansteigen des Werts des Spulenstroms nach jedem Einschalten des Spulenstroms wie auch das Absinken des Werts des Spulenstroms nach jedem Ausschalten folgt in der Regel einem etwa exponentiellen Verlauf mit einer charakteristischen Zeitkonstante, die von der Induktivität sowie dem ohmschen Widerstandanteil der Messspule abhängt.

Im Falle einer im Rahmen der Erfindung bevorzugten Verwendung eines "Vorwiderstands" in Reihenschaltung zur Messspule, der als "Messwiderstand" auch zur Erfassung des Spulenstroms verwendbar ist, hängen die genannten exponentiellen Verläufe bzw. somit die charakteristischen Zeitkonstanten auch vom Wert dieses Vorwiderstands ab.

Die Verwendung eines derartigen Vorwiderstands besitzt z.B. den Vorteil, dass die genannten exponentiellen Verläufe (und somit die Repräsentation der Induktivität durch das PWM-Tastverhältnis) weniger abhängig von Eigenschaften der verwendeten Stromquelle sind (z.B. Innenwiderstand der Stromquelle).

Da der Vorwiderstand ohne weiteres mit einem im Vergleich zum Temperaturkoeffizienten des ohmschen Widerstandsanteils der Messspule sehr kleinen Temperaturkoeffizienten vorgesehen werden kann, ist in der Regel die Kompensation der Temperaturabhängigkeit des Tastverhältnisses des PWM-Signals allein aufgrund einer Temperaturabhängigkeit des ohmschen Widerstands der Messspule in der Praxis völlig ausreichend.

Für die Temperaturkompensation wird gemäß der Erfindung ein stationärer maximaler Wert des Spulenstroms nach einem Einschalten und vor dem nachfolgenden Ausschalten des Spulenstroms erfasst. Unter Zugrundelegung eines exponentiellen Zeitverlaufs würde der maximale Wert des Stroms theoretisch erst nach unendlicher Wartezeit (nach dem Einschalten) erreicht werden. Im Rahmen der Erfindung ist diese Erfassung aus praktischer Sicht so zu verstehen, dass hierfür eine Wartezeit genügt, nach welcher sich der Wert des Spulenstroms nurmehr unwesentlich ändern würde, insbesondere z.B. um weniger als 10%, oder z.B. um weniger als 5%.

Sodann wird die Triggerschwelle in Abhängigkeit von dem zuvor erfassten Maximalwert des Spulenstroms entsprechend vorgegeben, d.h. beispielsweise bei einer Temperaturveränderung der Messspule so verändert, dass dies den Einfluss der Temperaturveränderung auf das PWM-Tastverhältnis zumindest teilweise kompensiert (Temperaturkompensation).

Mit der Temperaturkompensation wird vorteilhaft die Abhängigkeit des PWM-Tastverhältnisses von der Temperatur der Messspule verringert oder ganz beseitigt. Dies beruht darauf, dass der genannte Maximalwert des Spulenstroms nicht von der Induktivität, sondern nur vom ohmschen Widerstand der Messspule abhängt, der wiederum nur von der Temperatur der Messspule abhängt. Der Maximalwert des Spulenstroms bzw. z.B. ein diesen Maximalwert (bzw. Näherungswert hierfür) repräsentierendes Signal (z.B. Spannungsabfall am Messwiderstand nach hinreichend "langer" Einschaltdauer der Bestromung) kann somit vorteilhaft als ein Maß für die Temperatur der Messspule genutzt werden.

Basierend auf der entsprechenden Messgröße kann die Temperaturkompensation durch eine geeignete Vorgabe bzw. Nachführung (Aktualisierung) der Triggerschwelle bei Temperaturveränderungen bewerkstelligt werden.

In einer Ausführungsform der Erfindung geschieht dies analog, beispielsweise indem eine von der Messspulentemperatur abhängige Messspannung über ein Widerstandsnetzwerk einem Referenzeingang eines Komparators zugeführt wird, mit dessen Ausgangssignal eine entsprechende PWM-Signalflanke getriggert wird.

Bei dieser Messspannung kann es sich wie bereits erwähnt insbesondere z.B. um eine an dem genannten Vorwiderstand abfallende Spannung handeln, der in dieser Hinsicht dann auch als Messwiderstand (für die Erfassung des Werts des Spulenstroms) zu bezeichnen ist.

Alternativ ist es z.B. möglich, die genannte temperaturabhängige Spannung einer Analog/Digital-Wandlung zu unterziehen, d.h. digital zu erfassen, um sodann die Temperaturkompensation mittels digitaler Algorithmen einer auf einer digitalen Datenverarbeitungseinrichtung (z.B. Mikrocontroller) ablaufenden Software zu realisieren.

In einer Ausführungsform der Erfindung ist vorgesehen, dass die Schritte zum Kompensieren der Temperaturabhängigkeit des Tastverhältnisses nach jedem Einschalten des Spulenstroms durchgeführt werden.

In diesem Fall ist die Reaktionszeit der Temperaturkompensation minimal, da nach jedem "Messzyklus", der z.B. der von einem Einschaltzeitpunkt zum nächsten Einschaltzeitpunkt, oder z.B. von einem Ausschaltzeitpunkt zum nächsten Ausschaltzeitpunkt definiert sein kann, die Triggerschwelle zwecks Temperaturkompensation neu vorgegeben (aktualisiert) wird.

Ein in der Praxis zumeist bedeutsamerer Vorteil dieser Ausführungsform besteht jedoch darin, dass (im Gegensatz zu einigen der nachfolgend beschriebenen alternativen Ausführungen) das PWM-Signal kontinuierlich "ungestört" erzeugt und somit hinreichend genau insbesondere z.B. unter Verwendung einer einfachen Tiefpassfilterung ausgewertet werden kann.

In einer Ausführungsform der Erfindung ist vorgesehen, dass die Schritte zum Kompensieren der Temperaturabhängigkeit des Tastverhältnisses nach jedem n-ten Einschalten des Spulenstroms durchgeführt werden, wobei "n" eine ganze Zahl bezeichnet, die beispielsweise im Bereich von 2 bis 100 liegen kann.

In diesem Fall können insbesondere spezielle "Temperaturkompensationszyklen" vorgesehen sein, bei denen eine Zeitspanne zwischen einem Einschalten und dem nachfolgendem Ausschalten des Spulenstroms größer bemessen ist als bei "Messzyklen" zu Ermittlung der Induktivität.

Durch die größere Zeitspanne kann hierbei sichergestellt werden, dass der Spulenstrom am Ende des Temperaturkompensationszyklus seinen stationären maximalen Wert erreicht bzw. kann die Genauigkeit der Erfassung dieses stationären Maximalwerts des Spulenstroms erhöht werden.

Demgegenüber können bei den Messzyklen (zur Induktivitätsermittlung) derartige Zeitspannen zwischen Schaltvorgängen gegebenenfalls auch kürzer bemessen sein, da der Spulenstrom hierbei nicht den stationären Maximalwert sondern lediglich die Triggerschwelle erreichen muss.

Die Triggerschwelle kann betriebsmäßig, d.h. innerhalb eines in der Anwendungssituation zu erwartenden Temperaturbereiches, oder z.B. für eine bestimmte Referenztemperatur (z.B. Raumtemperatur), beispielsweise in einem Bereich von 5% bis 95%, bevorzugt 10% bis 90%, des stationären maximalen Werts des Spulenstroms liegen. In einer Ausführungsform ist vorgesehen, dass die Triggerschwelle entweder deutlich überhalb 50% (z.B. bei mindestens 70%) oder deutlich unterhalb 50% (z.B. bei höchstens 30%) des stationären maximalen Werts des Spulenstroms liegt.

Falls die Temperaturkompensation nach jedem zweiten Einschalten des Spulenstroms durchgeführt wird (n = 2), ergibt sich in der Regel wieder der Vorteil eines in einfacher Weise z.B. mittels einer Tiefpassfilterung hinreichend genau auswertbaren PWM-Signals.

Falls die Temperaturkompensation nur nach jedem dritten, vierten, fünften, ... Einschalten des Spulenstroms durchgeführt wird (n > 2), so können die entsprechend eher sporadisch "eingestreuten" Temperaturkompensationszyklen eine gewisse Störung des PWM-Signals darstellen, was im Falle einer Auswertung des PWM-Signals mittels Tiefpassfilterung eine entsprechend längere Zeitkonstante zweckmäßig macht (Mittelung über viele Zyklen).

Zugunsten einer höheren Auswertungsqualität kann in diesem Fall (n > 2) alternativ eine digitale Auswertung des PWM-Signals zweckmäßig sein, z.B. durch Auszählen der relevanten Zeitdauern oder durch Analog/Digital-Wandlung mit nachfolgender Auswertung durch eine digitale Datenverarbeitungseinrichtung.

In einer Ausführungsform der Erfindung ist vorgesehen, dass die Durchführung der Schritte zum Kompensieren der Temperaturabhängigkeit des Tastverhältnisses bedarfsweise durch ein Steuersignal befehligt wird.

In diesem Fall kann eine das Steuersignal ausgebende Steuereinrichtung beispielsweise separat von einer Schaltungsanordnung bzw. Steuereinrichtung angeordnet sein, mittels welcher die übrigen Schritte des Verfahrens zur Erfassung der Impedanz realisiert werden.

Alternativ und insbesondere z.B. bei einer Ermittlung einer Induktivität einer Messspule eines Sensors (z.B. Positionssensor oder Winkelsensor) interessant, kann bei dieser Ausführungsform auch eine einzige (baulich zusammengefasste) Steuereinrichtung vorgesehen sein, mittels welcher sowohl die Ermittlung der Induktivität durchgeführt wird, also die eigentliche Sensorfunktionalität, als auch das Steuersignal zur Befehligung einer Temperaturkompensation (z.B. eines "Temperaturkompensationszyklus") erzeugt wird.

Bei einer Verwendung des erfindungsgemäßen Verfahrens zum Betrieb eines Sensors (z.B. Positionssensor oder Winkelsensor) kann z.B. eine Steuereinrichtung vorgesehen sein, an welchem die Messspule baulich zusammengefasst angeordnet oder (über eine elektrische Leitungsverbindung wie z.B. Verkabelung) angeschlossen ist und welches z.B. nur vor jeder tatsächlichen Nutzung des Sensors das besagte Steuersignal erzeugt, und gegebenenfalls auch von Zeit zu Zeit (z.B. periodisch) während einer solchen Nutzung.

Schließlich ist hinsichtlich der Zeitpunkte der Durchführung der Temperaturkompensation auch eine Ausführungsform möglich, bei welcher eine zur Durchführung des erfindungsgemäßen Verfahrens eingesetzte Steuereinrichtung (mit Mitteln für die Bestromung, die Stromerfassung, den Stromwertvergleich mit der Triggerschwelle etc.) eine digitale Schnittstelle (z.B. CAN-Schnittstelle oder dergleichen) aufweist, über welche von extern, z.B. über einen digitalen Kommunikationsbus (z.B. CAN-Bus), ein Steuersignal zugeführt werden kann, mit welchem die Steuereinrichtung in verschiedene Betriebsmodi versetzt werden kann, z.B. entsprechend den vorstehend erläuterten Ausführungsformen mit Temperaturkompensation nach jedem Einschalten, nach jedem n-ten Einschalten, oder bedarfsweise.

In einer Ausführungsform der Erfindung ist vorgesehen, dass die Messspule durch ein metallisches Material gebildet ist, also z.B. durch eine Wicklung aus metallischem Material oder durch eine Leiterbahn aus metallischem Material auf einer Schaltungsträgerplatte. An dieser Schaltungsträgerplatte kann hierbei ferner zumindest ein Teil der elektrischen und/oder elektronischen Komponenten der zur Durchführung des erfindungsgemäßen Verfahrens eingesetzten Schaltungsanordnung angeordnet sein.

Bei dem metallischen Material der Messspule kann es sich insbesondere z.B. um ein Kupfermaterial (Kupfer oder Kupferlegierung) handeln.

Der Einsatz derartigen Materials zur Ausbildung der Messspule ist in vielen Anwendungsgebieten bevorzugt, bringt jedoch in der Regel einen relativ großen linearen Widerstand-Temperaturkoeffizienten mit sich. Technisches Kupfer hat einen linearen Widerstand-Temperaturkoeffizienten von etwa $4 \times 10^{-3}$ K$^{-1}$, was bei Temperaturschwankungen zwischen Raumtemperatur (25°C) und 125°C den ohmschen Widerstandswert der Messspule um etwa 40% variieren lässt.

Die mit der Erfindung bewerkstelligte Temperaturkompensation vermag jedoch vorteilhaft einen Einfluss auch derart großer Widerstandsänderungen auf das für die Induktivität repräsentative PWM-Signal zu beseitigen.

Insofern eignet sich die Verwendung eines Verfahrens und/oder einer Schaltungsanordnung der hier beschriebenen Art hervorragend für mobile Anwendungen, beispielsweise in einem Fahrzeug, beispielsweise zur Ermittlung einer Induktivität einer Messspule eines in einem Fahrzeug angeodneten induktiven Sensors wie z.B. eines Positionssensors oder eines Winkelsensors.

In einer Ausführungsform der Erfindung ist vorgesehen, dass der Spulenstrom über einen (als "Vorwiderstand") in Reihenschaltung zur Messspule angeordneten Messwiderstand geführt wird und die Erfassung des Werts des Spulenstroms durch eine Erfassung einer am Messwiderstand abfallenden Spannung realisiert wird.

Die Verwendung eines derartigen Messwiderstands erlaubt nicht nur die einfache Erzeugung eines für den Spulenstrom repräsentativen Spannungssignals (proportional zum Spulenstrom), sondern besitzt auch die weiter oben in Bezug auf einen solchen Vorwiderstand erläuternden Vorteile.

Es versteht sich, dass die an einem Messwiderstand abfallende Spannung sowohl für das Erfassen des Werts des Spulenstroms zwecks Triggerung der betreffenden PWM-Signalflanken (sobald der Wert des Spulenstroms die vorgegebene Triggerschwelle erreicht) als auch für das Erfassen des stationären maximalen Werts des Spulenstroms im Rahmen der Temperaturkompensation genutzt werden kann.

Gemäß eines zweiten Aspekts der vorliegenden Erfindung wird die eingangs genannte Aufgabe durch eine Schaltungsanordnung zur Ermittlung einer Induktivität einer Messspule gelöst, aufweisend

- eine Bestromungseinrichtung zum Einschalten und Ausschalten eines durch die Messspule fließenden Spulenstroms zu Einschaltzeitpunkten und Ausschaltzeitpunkten, die mit Hilfe eines Taktsignals vorgegeben werden,

- eine PWM-Signal-Erzeugungseinrichtung zum Erzeugen eines PWM-Signals mit einem für die Induktivität der Messspule repräsentativen Tastverhältnis, indem das PWM-Signal mit steigenden und fallenden PWM-Signalflanken erzeugt wird, die einerseits zeitgleich mit dem Einschalten oder mit dem Ausschalten des Spulenstroms getriggert werden und andererseits getriggert werden, sobald ein Wert des Spulenstroms eine vorgegebene Triggerschwelle erreicht, oder alternativ beide jeweils getriggert werden, sobald ein Wert des Spulenstroms eine vorgegebene Triggerschwelle erreicht, aufweisend

- eine Triggervorgabeeinrichtung zur Vorgabe der Triggerschwelle,

- eine Erfassungs- und Vergleichseinrichtung zum Erfassen eines Werts des Spulenstroms und zum Vergleichen dieses Werts mit der vorgegebenen Triggerschwelle,

- eine Auswerteeinrichtung zum Auswerten des PWM-Signals, um dessen Tastverhältnis und daraus die Induktivität der Messspule zu ermitteln,

wobei die PWM-Signal-Erzeugungseinrichtung für eine Kompensation einer Temperaturabhängigkeit des Tastverhältnisses des PWM-Signals aufgrund einer Temperaturabhängigkeit eines ohmschen Widerstands der Messspule ferner aufweist:

- eine Erfassungs- und Vorgabeaktualisierungseinrichtung zum Erfassen eines stationären maximalen Werts des Spulenstroms nach einem Einschalten und vor dem nachfolgenden Ausschalten des Spulenstroms und zum Vorgeben der Triggerschwelle in Abhängigkeit von dem erfassten stationären maximalen Wert des Spulenstroms.

Die für das erfindungsgemäße Verfahren hier beschriebenen Ausführungsformen und besonderen Ausgestaltungen können, einzeln oder in beliebiger Kombination, in analoger Weise auch als Ausführungsformen bzw. besondere Ausgestaltungen der erfindungsgemäßen Schaltungsanordnung vorgesehen sein, und umgekehrt.

In einer Ausführungsform der Schaltungsanordnung ist vorgesehen, dass die Erfassungs- und Vergleichseinrichtung aufweist:

- einen Messwiderstand, der bei der Ermittlung der Induktivität der Messspule in Reihenschaltung zur Messspule angeordnet ist und über den der Spulenstrom geführt wird,

- einen Komparator zum Vergleichen einer am Messwiderstand abfallenden Spannung mit einer als Triggerspannung vorgegebenen Triggerschwelle.

In einer Weiterbildung dieser Ausführungsform ist vorgesehen, dass die Erfassungs- und Vorgabeaktualisierungseinrichtung eine Abtast-Halte-Schaltung zum Abtasten und Halten einer am Messwiderstand abfallenden Spannung aufweist.

Gemäß eines weiteren Aspekts der vorliegenden Erfindung wird eine Verwendung eines Verfahrens und/oder einer Schaltungsanordnung der hier beschriebenen Art zur Ermittlung einer Induktivität einer Messspule eines induktiven Sensors vorgeschlagen.

Die Erfindung ist insbesondere interessant für mobile Anwendungen, beispielsweise in einem Fahrzeug. Insbesondere in einer derartigen Anwendung kann es sich bei dem Sensor z.B. um einen im Fahrzeug angeordneten Positionssensor oder Winkelsensor handeln, mittels welchem eine Position (z.B. Verstellposition) bzw. ein Winkel (z.B. Verstellwinkel) einer verlagerbaren Komponente des Fahrzeuges basierend auf der ermittelten Induktivität ermittelt wird.

Bei der Komponente kann es sich z.B. um eine Drosselklappe einer Brennkraftmaschine des Fahrzeuges oder z.B. um ein Karosserieteil wie z.B. eine Tür oder Klappe des Fahrzeuges handeln.

Die Erfindung wird nachfolgend anhand von Ausführungsbeispielen mit Bezug auf die beigefügten Zeichnungen weiter beschrieben. Es stellen dar:

Fig. 1 eine Schaltungsanordnung zur Ermittlung einer Induktivität einer Messspule gemäß eines Ausführungsbeispiels,

Fig. 2 beispielhafte zeitliche Verläufe verschiedener Strom- und Spannungswerte im Betrieb der Schaltungsanordnung von Fig. 1,

Fig. 3 eine Schaltungsanordnung zur Ermittlung einer Induktivität einer Messspule gemäß eines weiteren Ausführungsbeispiels, und

Fig. 4 beispielhafte zeitliche Verläufe verschiedener Strom- und Spannungswerte im Betrieb der Schaltungsanordnung von Fig. 3.

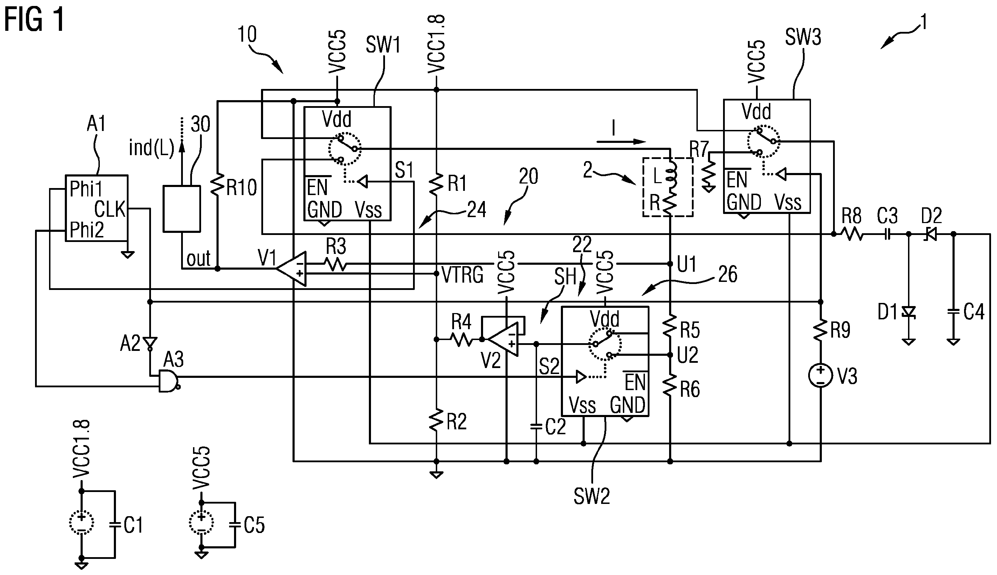

Fig. 1 zeigt eine Schaltungsanordnung 1 zur Ermittlung einer Induktivität L einer Messspule 2. Bei der Messspule 2 handelt es sich beispielsweise um eine Messspule eines induktiven Sensors, mittels welchem z.B. eine Verstellposition oder z.B. ein Verstellwinkel einer verlagerbaren Komponente in einem Fahrzeug gemessen wird. Dies basierend auf einer bestimmten Abhängigkeit der Induktivität L von einer solchen Position bzw. einem solchen Winkel.

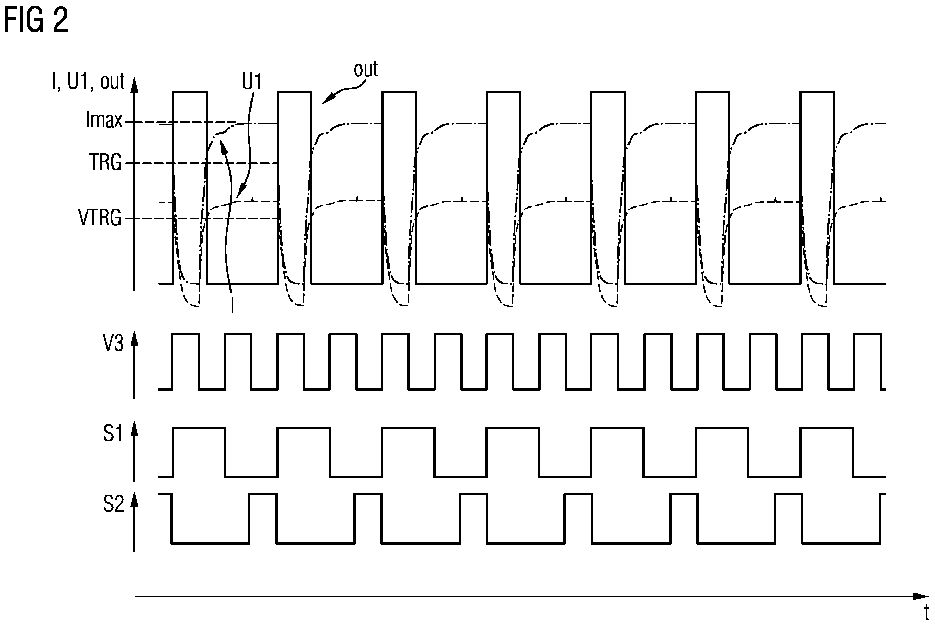

Bevor die in Fig. 1 gezeigte Schaltungsanordnung 1 detaillierter beschrieben wird, seien zunächst bezugnehmend zusätzlich auf Fig. 2 die Schritte des mit der Schaltungsanordnung 1 durchgeführten Verfahrens wie folgt beschrieben:

a) Einschalten und Ausschalten eines durch die Messspule 2 fließenden Spulenstroms I zu Einschaltzeitpunkten und Ausschaltzeitpunkten, die mit Hilfe eines Taktsignals V3 vorgegeben werden (In Fig. 2 ist das Taktsignal in Abhängigkeit von der Zeit t aufgetragen).

Im dargestellten Beispiel ist das Taktsignal V3 ein periodisches rechteckförmiges Spannungssignal (im Beispiel 5V, 2 kHz, 50% Tastverhältnis), wobei wie in Fig. 2 ersichtlich jede im zeitlichen Verlauf dritte fallende Taktsignalflanke einen Einschaltzeitpunkt der Bestromung definiert, und wobei die jeweils unmittelbar vorausgehenden steigenden Taktsignalflanken jeweils einen Ausschaltzeitpunkt definieren. Daraus ergibt sich in diesem Beispiel, dass periodische Bestromungszyklen durch eine frequenzgeteilte Version des verwendeten Taktsignals (hier: V3) getaktet werden und dass die Einschaltzeitphasen länger als die Ausschaltzeitphasen bemessen sind. Im Beispiel von Fig. 2 entspricht die Frequenz der Einschaltvorgänge (bzw. Ausschaltvorgänge) der Hälfte der Frequenz des Taktsignals V3.

b) Erzeugen eines PWM-Signals "out" mit steigenden und fallenden PWM-Signalflanken, die einerseits (in Fig. 2 steigende Flanken) getriggert werden, sobald ein Wert des infolge der ausgeschalteten Bestromung sinkenden Spulenstroms I eine vorgegebene Triggerschwelle "TRG" unterschreitet, und andererseits (in Fig. 2 fallende Flanken) getriggert werden, sobald ein Wert des infolge der eingeschalteten Bestromung steigenden Spulenstroms I die vorgegebene Triggerschwelle TRG überschreitet.

In jeder Einschaltphase der Bestromung steigt ein Wert des Spulenstroms I, wohingegen in jeder Ausschaltphase der Bestromung der Wert des Spulenstroms I wieder absinkt, wobei in beiden Phasen der Wert des Spulenstroms I jeweils einem etwa exponentiellen Verlauf mit einer charakteristischen Zeitkonstante (hier etwa: $L / (R5+R6)$) folgt. Die Triggerschwelle TRG ist zweckmäßigerweise in einem mittleren Bereich des exponentiellen Verlaufs des Spulenstroms I liegend vorgegeben. Aufgrund der Abhängigkeit der Verläufe des Spulenstroms I bzw. deren Zeitkonstanten von der Induktivität L der Messspule 2 besitzt das PWM-Signal out ein für die Induktivität L repräsentatives Tastverhältnis.

c) Auswerten des PWM-Signals out, um dessen Tastverhältnis und daraus die Induktivität L der Messspule 2 zu ermitteln und z.B. als ein digitales Datensignal "ind(L)" bereitzustellen, beispielsweise an einem digitalen Datenbus eines Fahrzeuges.

Im Beispiel der Fig. 1 und 2 wird ein z.B. als Verhältnis von Pulsdauer zu PWM-Periodendauer definiertes Tastverhältnis des PWM-Signals out mit steigender Induktivität L größer und mit sinkender Induktivität L kleiner. Unter Nutzung dieses beispielsweise vorab berechneten oder vorab empirisch bestimmten Zusammenhangs kann durch das Auswerten des PWM-Signals out somit die Induktivität L der Messspule 2 ermittelt werden.

Zu bedenken ist jedoch, dass bei einer Variation einer Temperatur der Messspule 2, beispielsweise aufgrund einer variierenden Umgebungstemperatur in einer mobilen Anwendung, auch ein Widerstand R der Messspule 2 (d.h. ohmscher Anteil der Impedanz der Messspule 2) bei Variation der Messspulentemperatur variiert, so dass das besagte Tastverhältnis des PWM-Signals out in der Praxis nicht nur von der Induktivität L sondern zusätzlich von der Temperatur der Messspule 2 abhängt.

Das Verfahren umfasst daher für eine Kompensation dieser Temperaturabhängigkeit des Tastverhältnisses des PWM-Signals out (aufgrund einer Temperaturabhängigkeit des ohmschen Widerstands R der Messspule 2) ferner die Schritte:

d) Erfassen eines stationären maximalen Werts "Imax" des Spulenstroms I nach einem Einschalten (jedoch vor dem nachfolgenden Ausschalten) des Spulenstroms I, und

e) Vorgeben (bzw. Aktualisieren) der Triggerschwelle TRG in Abhängigkeit von dem erfassten stationären maximalen Wert Imax des Spulenstroms I.

Mit dieser Temperaturkompensation wird vorteilhaft erreicht, dass eine ansonsten wie erläutert bestehende Abhängigkeit des Tastverhältnisses des Signals out von der Temperatur beseitigt oder zumindest reduziert wird.

Im Beispiel des in Fig. 2 dargestellten zeitlichen Verlaufs sei angenommen, dass weder die Induktivität L noch die Temperatur (und somit der Widerstand R) variiert, so dass sich das Tastverhältnis des PWM-Signals out im zeitlichen Verlauf nicht ändert.

Würde jedoch beispielsweise die Induktivität L bei weiterhin konstanter Temperatur steigen, so würde das Tastverhältnis größer werden und basierend darauf diese Steigerung von L bei der Auswertung ermittelt werden (wobei der ermittelte maximale Wert Imax des Spulenstroms I jedoch konstant bleibt).

Würde beispielsweise, bei konstanter Induktivität L, die Temperatur und dadurch bedingt der Widerstand R steigen, so würde der ermittelte maximale Wert Imax des Spulenstroms I sinken, woraufhin durch die Temperaturkompensation die Triggerschwelle TRG in Abhängigkeit vom erfassten Wert Imax so verändert wird, dass das Tastverhältnis konstant bleibt, und somit durch die Auswertung des Tastverhältnisses die Konstanz der Induktivität L korrekt erkannt wird.

Betreffend die Erfassung des stationären maximalen Werts Imax des Spulenstroms I nach einem Einschalten ist in Fig. 2 gut zu erkennen, dass nach Ablauf der im Beispiel gewählten "Wartezeit" entsprechend 1,5 Perioden des Taktsignals V3 sich der Wert des Spulenstroms I im Verlauf der Zeit t nurmehr unwesentlich ändern würde (hier z.B. um weniger als 1%). Der am Ende dieser Wartezeit erfasste Wert Imax des Stromes I entspricht daher sehr genau dem unter Zugrundelegung eines exponentiellen Zeitverlaufs mit einer Zeitkonstante "tau"

$$I(t) = Imax,theo \times (1 - exp(-t / tau))$$

theoretisch erst nach unendlicher Wartezeit sich ergebenden Maximalstrom "Imax,theo". Im Rahmen der Erfindung erfolgt die Erfassung bevorzugt nach einer Zeitspanne von mindestens 2 x tau, weiter bevorzugt mindestens 4 x tau. Damit ist der erfasste Wert Imax ein hinreichend guter Näherungswert für den tatsächlichen Maximalstrom.

Zurückkommend auf Fig. 1 weist die Schaltungsanordnung 1 eine Bestromungseinrichtung 10 auf, mittels welcher im Betrieb der Schaltungsanordnung 1 der durch die Messspule 2 fließende Spulenstrom I eingeschaltet und ausgeschaltet werden kann, wobei die entsprechenden Einschaltzeitpunkte und Ausschaltzeitpunkte mit Hilfe des Taktsignals V3 vorgegeben werden.

Wie aus Fig. 1 ersichtlich werden aus dem Taktsignal V3 weitere frequenzgeteilte Taktsignale bzw. Ansteuersignale S1 und S2 gebildet, deren zeitlicher Verlauf ebenfalls in Fig. 2 dargestellt ist.

Die Erzeugung des Taktsignals V3 ist in Fig. 1 durch eine entsprechende Spannungsquelle symbolisiert. Ebenso ist eine elektrische Versorgung der Schaltungsanordnung 1 mit im Beispiel zwei Versorgungsspannungen VCC5 und VCC1.8 in Fig. 1 durch entsprechende Spannungsquellen symbolisiert.

Das Einschalten und Ausschalten der Bestromung der Messspule 2 (Spulenstrom I) erfolgt wie in Fig. 1 ersichtlich mittels einer ansteuerbaren Schalteinrichtung SW1 (angesteuert durch S1) und einer ansteuerbaren Schalteinrichtung SW3 (angesteuert durch V3), welche einen ersten Anschluss der Messspule 2 alternierend (zu den entsprechenden Schaltzeitpunkten) entweder mit der Versorgungsspannung VCC1.8 oder über einen Widerstand R7 mit einem Massepotential GND verbinden.

Ein zweiter Anschluss der Messspule 2 ist über einen Messwiderstand R5, R6 (Reihenschaltung aus Einzelwiderständen R5 und R6) mit dem Massepotential GND verbunden.

Im Beispiel von Fig. 1 wird die Schalteinrichtung SW3 außerdem dazu verwendet eine von den Versorgungsspannungen VCC1.8 und VCC5 verschiedene weitere (Hilfs-)Versorgungsspannung Vss zu erzeugen. Die weitere Versorgungsspannung Vss wird ausgehend von der Versorgungsspannung VCC5 mit Hilfe einer Spannungswandlerschaltung erzeugt, die wie dargestellt mit den Komponenten SW3, R7, R8, C3, D1, D2, C4 ausgebildet ist und welche für deren Funktion ebenfalls das Taktsignal V3 nutzt.

Die Schaltungsanordnung 1 weist ferner eine PWM-Signal-Erzeugungseinrichtung 20 auf, mittels welcher das PWM-Signal out mit dem für die Induktivität L der Messspule 2 repräsentativen Tastverhältnis erzeugt werden kann, indem das PWM-Signal out mit entsprechend getriggerten PWM-Signalflanken (siehe Fig. 2) erzeugt wird.

Im dargestellten Beispiel von Fig. 1 werden hierfür, wie mit Bezug auf Fig. 2 bereits erläutert, die steigenden PWM-Signalflanken jeweils zeitgleich mit dem Unterschreiten der vorgegebenen Triggerschwelle TRG durch den Wert des sinkenden Spulenstroms I getriggert und werden die fallenden PWM-Signalflanken jeweils getriggert, sobald der Wert des steigenden Spulenstroms I die vorgegebene Triggerschwelle TRG erneut erreicht bzw. überschreitet.

Insbesondere da hierbei für die Triggerschwelle TRG ein Wert gewählt ist, der deutlich oberhalb 50% des oben erläuterten maximalen Stromwerts Imax liegt, erfolgt das Triggern der steigenden PWM-Signalflanken sehr kurz nach dem Ausschalten des Spulenstroms I. Der Spulenstrom I sinkt im relevanten Zeitbereich exponentiell sehr steil ab, so dass die Triggerschwelle TRG stets sehr rasch erreicht wird, wobei eine Variation der Induktivität L der Messspule 2 diese Zeitspanne bis zum Erreichen der Triggerschwelle TRG nur sehr wenig beeinflusst (Abweichend vom Schaltungsbeispiel gemäß Fig. 1 könnte daher z.B. auch vorgesehen sein, dass die steigende PWM-Signalflanke völlig starr an die ansteigende Flanke des Taktsignals V3 gekoppelt wird, d.h. jede steigende PWM-Signalflanke zeitgleich mit einer jeweiligen steigenden Flanke des Taktsignals V3 getriggert wird).

Demgegenüber erfolgt das Triggern der fallenden PWM-Signalflanken in einem Zeitbereich, in dem der exponentiell ansteigende Verlauf des Spulenstroms I bereits relativ flach verläuft, so dass eine nennenswerte und relativ stark von der Induktivität L abhängige Zeitspanne zwischen dem Einschalten des Spulenstroms I und dem Erreichen der Triggerschwelle TRG vergeht.

Die PWM-Signal-Erzeugungseinrichtung 20 weist eine Triggervorgabeeinrichtung 22 zur Vorgabe der Triggerschwelle TRG und eine Erfassungs- und Vergleichseinrichtung 24 zum Erfassen eines Werts des Spulenstroms I und zum Vergleichen dieses Werts mit der vorgegebenen Triggerschwelle TRG auf.

Im Beispiel weist die Erfassungs- und Vergleichseinrichtung 24 den als Reihenschaltung aus Einzelwiderständen R5 und R6 vorgesehenen Messwiderstand R5, R6 auf, der wie in Fig. 1 ersichtlich bei an der Schaltungsanordnung 1 angeschlossener Messspule 2 in Reihenschaltung zur Messspule 2 angeordnet ist und über den somit der Spulenstrom I geführt wird.

Des Weiteren umfasst die Erfassungs- und Vergleichseinrichtung 24 im Beispiel einen Komparator V1 (hier z.B. Operationsverstärker) zum Vergleichen einer am Messwiderstand R5, R6 abfallenden Spannung mit der in diesem Beispiel als Triggerspannung VTRG vorgegebenen Triggerschwelle TRG. In dieser Weise wird am Ausgang des Komparators V1 das PWM-Signal out bereitgestellt.

Hierbei ist ein erster (invertierender) Eingang des Komparators V1 über einen Widerstand R3 mit einem Abgriff zwischen der Messspule 2 und dem Messwiderstand R5, R6 verbunden und ein zweiter (nicht-invertierender) Eingang des Komparators V1 mit der Triggerspannung VTRG beaufschlagt.

Der Komparator V1 vergleicht somit eine zeitlich veränderliche Spannung an seinem invertierenden Eingang, die repräsentativ für den Wert von I ist und nachfolgend auch als erste Messspannung U1 bezeichnet wird, mit der als "Referenzspannung" an seinem nicht-invertierenden Eingang anliegenden Triggerspannung VTRG. Ist letztere höher als erstere, so gibt der Komparator V1 einen "High-Pegel" aus, andernfalls einen "Low-Pegel".

Die Schaltungsanordnung 1 weist ferner eine in Fig. 1 schematisch als Funktionsblock dargestellte Auswerteeinrichtung 30 auf, mittels welcher das PWM-Signal out ausgewertet wird, um dessen Tastverhältnis und daraus die Induktivität L der Messspule 2 zu ermitteln. Die Information über den Wert der Induktivität L wird von der Auswerteeinrichtung 30 beispielsweise in Form eines digitalen Datensignals ind(L) ausgegeben.

Eine Besonderheit der Schaltungsanordnung 1 besteht darin, dass die PWM-Signal-Erzeugungseinrichtung 20 ferner eine Erfassungs- und Vorgabeaktualisierungseinrichtung 26 aufweist, mit deren Hilfe die oben bereits erläuterte Temperaturkompensation bewerkstelligt wird, d.h. eine Temperaturabhängigkeit des Tastverhältnisses des PWM-Signals out beseitigt oder zumindest verringert wird, die ansonsten aus einer Temperaturabhängigkeit des ohmschen Widerstands R der Messspule 2 resultieren und somit das Ermittlungsergebnis betreffend die Induktivität L verfälschen würde.

Mittels der Erfassungs- und Vorgabeaktualisierungseinrichtung 26 wird, im dargestellten Beispiel von Fig. 1 periodisch, der stationäre maximale Wert Imax des Spulenstroms I nach einem Einschalten, jedoch vor dem nachfolgenden Ausschalten des Spulenstroms I erfasst.

In Abhängigkeit von dem so erfassten Wert Imax wird mittels der Erfassungs- und Vorgabeaktualisierungseinrichtung 26 sodann die Triggerschwelle TRG (hier: Triggerspannung VTRG) vorgegeben bzw. aktualisiert.

Im Beispiel umfasst die Erfassungs- und Vorgabeaktualisierungseinrichtung 26 eine Abtast-Halte-Schaltung SH zum Abtasten und Halten einer am Messwiderstand R5, R6 abfallenden Spannung, nachfolgend auch als zweite Messspannung U2 bezeichnet, die proportional und somit repräsentativ für den Wert des Spulenstroms I ist. Speziell im Zusammenhang mit dem Messwiderstand (R5, R6) ist von dem Begriff "am Messwiderstand abfallende Spannung" auch mitumfasst die im dargestellten Beispiel von Fig. 1 vorgesehene Ausführungsform, bei welcher die zweite Messspannung U2 im engeren Sinne nur an einem der beiden Einzelwiderstände (R5 und R6), hier dem Einzelwiderstand R6, des als Reihenschaltung vorgesehenen Messwiderstands (R5, R6) abfällt. Diese Maßnahme besitzt z.B. den Vorteil, dass durch entsprechende Bemessung der Einzelwiderstände R5 und R6 und Abtasten der zwischen R5 und R6 abgegriffenen Spannung U2 in einfacher Weise eine Skalierung der maßgeblichen (d.h. von der Abtast-Halte-Schaltung SH zu haltenden) Spannung U2 realisiert wird. Im Beispiel entspricht diese Skalierung einer Teilung der ersten Messspannung U1 im Verhältnis R6 / (R5 + R6).

Die Abtast-Halte-Schaltung SH umfasst im Beispiel von Fig. 1 eine ansteuerbare Schalteinrichtung SW2 (angesteuert durch S2), einen Kondensator C2 und einen Spannungsfolger V2, der im Beispiel durch einen hierfür entsprechend beschalteten Operationsverstärker implementiert ist.

Die Schalteinrichtung SW2 wird mit Hilfe einer durch das Taktsignal V3 betriebenen Logikgatteranordnung A1 (Flip-Flop), A2, A3 und dem damit erzeugten Ansteuersignal S2 so angesteuert, dass zu den damit geeignet definierten Zeitpunkten die zwischen R5 und R6 abgegriffene zweite Messspannung U2 über die Schalteinrichtung SW2 an den als "Spannungsspeicher" fungierenden Kondensator C2 angelegt wird, welcher diese Spannung solange hält, bis die Schalteinrichtung SW2 das nächste Mal die Spannung U2 am Abgriff zwischen R5 und R6 abtastet.

Die abgetastete und gehaltene Spannung U2 wird im dargestellten Beispiel sodann mit Hilfe des als Spannungsfolger V2 beschalteten Operationsverstärkers "niederohmig" am Ausgang des Operationsverstärkers, d.h. Ausgang der Abtast-Halte-Schaltung SH, bereitgestellt.

Eine im Beispiel von Fig. 1 ersichtliche weitere vorteilhafte Besonderheit der Erfassungs- und Vorgabeaktualisierungseinrichtung 26 besteht darin, dass die von der Abtast-Halte-Schaltung SH gehaltene Spannung U2 (am Kondensator C2 bzw. am Ausgang des Spannungsfolgers V2) nicht unmittelbar als die besagte Triggerspannung VTRG (zur Definition der Triggerschwelle TRG) verwendet wird, sondern mit Hilfe eines Widerstandnetzwerks erst in die Triggerspannung VTRG gewandelt wird, wodurch vorteilhaft eine weitere "Skalierung" realisiert wird.

Das Widerstandsnetzwerk umfasst im Beispiel wie dargestellt einen "Koppel"-Widerstand R4 und eine an der Versorgungsspannung VCC1.8 angeschlossene Reihenschaltung aus Einzelwiderständen R1 und R2, wobei der Widerstand R4 zwischen einem Ausgang der Abtast-Halte-Schaltung SH (hier: Ausgang des Spannungsfolgers V2) und einem Abgriff der Reihenschaltung (zwischen R1 und R2) angeschlossen ist. Die in dieser Weise am Abgriff der Reihenschaltung R1, R2 bereitgestellte Spannung wird als die Triggerspannung VTRG verwendet (und wie bereits erläutert an einen Eingang des Komparators V1 angelegt).

Die vorgenannte Skalierung der Triggerspannung VTRG kann vorteilhaft z.B. so vorgesehen sein, dass bei einer bestimmten ("Referenz-")Temperatur wie z.B. Raumtemperatur (z.B. 25°C) die Triggerspannung VTRG am Ausgang des Spannungsfolgers V2 gleich der sich durch die Bemessung von R1 und R2 am Mittelabgriff der Reihenschaltung R1, R2 ergebenden Spannung ist, so dass bei dieser Temperatur der Spannungsfolger V2 nicht in den Schaltvorgang des Komparators V1 eingreift.

Die vorgenannte Skalierung der Triggerspannung VTRG durch das Beaufschlagen des Referenzeingangs des Komparators V1 über das Widerstandsnetzwerk R1, R2, R4 mit einer von der Messspulentemperatur abhängigen Spannung, hier der zweiten Messspannung U2, ist im dargestellten Beispiel gleichzeitig auch eine vorteilhafte Maßnahme, mittels welcher wesentliche Parameter der gewünschten Temperaturkompensation eingestellt bzw. optimiert werden können.

Im Beispiel sind hierbei die Werte der Widerstände R4 sowie R5, R6 (in Verbindung mit den Werten von R1 und R2) so ausgelegt, dass eine durch Temperaturänderung hervorgerufene Absenkung/Anhebung der ersten Messspannung U1 möglichst genau kompensiert wird durch eine daraufhin erfolgende Absenkung/Anhebung der Referenzspannung VTRG, so dass die Pulsbreite des PWM-Signals out unabhängig von der Temperatur ist.

Dieses von der Erfassungs- und Vergleichseinrichtung 24 ausgegebene pulsförmige Signal (PWM-Signal out) wird der Auswerteeinrichtung 30 eingegeben, welche basierend auf entsprechender Auswertung schließlich das für den Wert der Induktivität L repräsentative Datensignal ind(L) bereitstellt.

In der Auswerteeinrichtung 30, die z.B. eine funktionale Komponente eines zum Betrieb des entsprechenden Sensors vorgesehenen Steuereinrichtung darstellen kann, kann z.B. eine sog. "Capture"-Einheit vorgesehen sein, mittels welcher das PWM-Signal out ausgezählt wird, um das Tastverhältnis bzw. somit den Wert der Induktivität L zu ermitteln. Alternativ kann das Signal out beispielsweise mittels eines Tiefpassfilters geglättet und als analoges Messsignal und/oder mittels eines A/D-Wandlers noch gewandelt als digitales Datensignal ausgegeben werden.

Im Falle einer Ermittlung der Induktivität L im Rahmen des Betriebs eines Sensors kann das aus der Auswertung resultierende Signal (z.B. Datensignal ind(L)) das für die betreffende Sensormessgröße (z.B. Position, Winkel, etc.) repräsentative Sensorsignal darstellen.

Bei der nachfolgenden Beschreibung von weiteren Ausführungsbeispielen werden für gleichwirkende Komponenten die gleichen Bezugszeichen verwendet. Dabei wird im Wesentlichen nur auf die Unterschiede zu dem bzw. den bereits beschriebenen Ausführungsbeispielen eingegangen und im Übrigen hiermit ausdrücklich auf die Beschreibung vorangegangener Ausführungsbeispiele verwiesen.

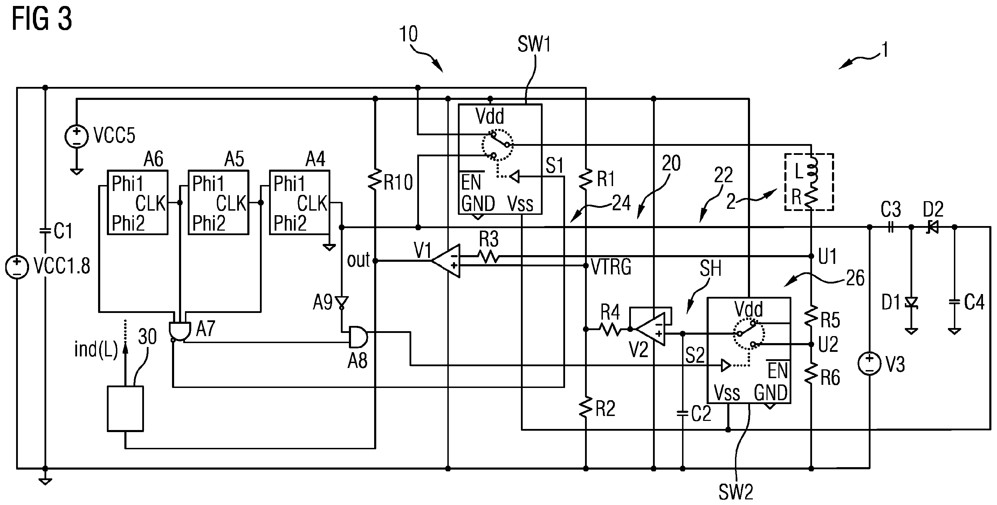

Fig. 3 zeigt ein weiteres Ausführungsbeispiel einer Schaltungsanordnung 1 zur Ermittlung einer Induktivität L einer Messspule.

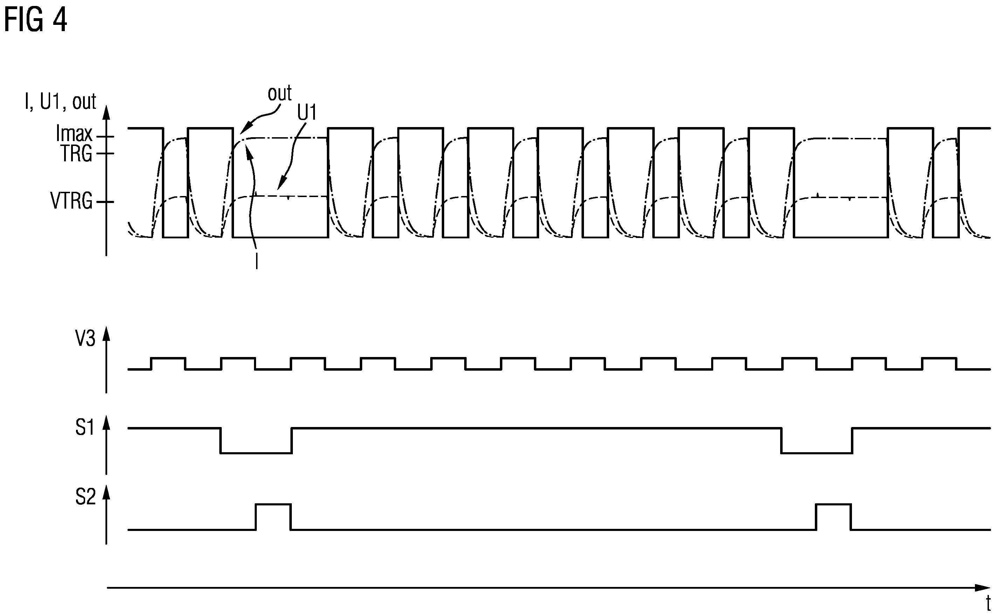

Fig. 4 zeigt in einer der Fig. 2 entsprechenden Darstellung im Betrieb der Schaltungsanordnung von Fig. 3 sich ergebende zeitliche Verläufe verschiedener Strom- und Spannungswerte.

Im Unterschied zu dem bereits beschriebenen Ausführungsbeispiel der Fig. 1 und 2 ist bei dem Beispiel der Fig. 3 und 4 vorgesehen, dass die Schritte zum Kompensieren der Temperaturabhängigkeit des Tastverhältnisses des PWM-Signals out nicht nach jedem Einschalten, sondern nur nach jedem achten Einschalten des Spulenstroms I durchgeführt werden.

Nach jeweils sieben "Messzyklen" zur Ermittlung der Induktivität L folgt ein "Temperaturkompensationszyklus" zur Aktualisierung der Triggerschwelle TRG.

Die in Fig. 3 gezeigte Schaltungsanordnung 1 entspricht in Aufbau und Funktion im Wesentlichen der bereits beschriebenen Ausführung von Fig. 1.

Ein im Hinblick auf den vorgenannten funktionalen Unterschied betreffend die Durchführung der Temperaturkompensationszyklen notwendiger schaltungstechnischer Unterschied besteht jedoch in Aufbau und somit Funktion einer Logikgatteranordnung A4, A5, A6, A8, A9 des Beispiels von Fig. 3.

Mittels dieser Logikgatteranordnung A4, A5, A6, A8, A9 erfolgt zwar ebenfalls eine getaktete Ansteuerung der Erfassungs - und Vorgabeaktualisierungseinrichtung 26 (dort: mit Ansteuersignal S2 angesteuerte Schalteinrichtung SW2) und der Bestromungseinrichtung 10 (dort: mit Ansteuersignal S1 angesteuerte Schalteinrichtung SW1), dies jedoch so, dass wie vorerwähnt die Schritte der Temperaturkompensation nur nach jedem achten Einschalten des Spulenstroms I durchgeführt werden.

In diesem Zusammenhang besteht ein weiterer Unterschied darin, dass im Beispiel von Fig. 3 die Frequenz der Einschaltvorgänge (bzw. Ausschaltvorgänge) der Bestromung der Messspule 2 während der Messzyklen gleich der Frequenz des Taktsignals V3 ist.

Ein noch weiterer Unterschied besteht in der konkreten Art und Weise der Erzeugung der weiteren ("Hilfs-")Versorgungsspannung Vss. Im Beispiel von Fig. 3 ist hierfür wie dargestellt eine Spannungserzeugungsschaltung mit Hilfe der Komponenten C3, D1, D2, C4 ausgebildet, welche für deren Funktion das Taktsignal V3 nicht nur für eine Taktung, sondern zusätzlich als "Versorgungsspannungsquelle" nutzt (wohingegen im Beispiel von Fig. 1 eine entsprechende Versorgung mittels der Versorgungsspannung VCC1.8 erfolgt).

Mit der Erfindung und den beschriebenen Ausführungsbeispielen können vorteilhaft induktive Sensoren mit einer besonders einfachen und zuverlässigen Temperaturkompensation betrieben werden.

**Patentansprüche**

1. Verfahren zur Ermittlung einer Induktivität (L) einer Messspule (2), umfassend die Schritte:

   - Einschalten und Ausschalten eines durch die Messspule (2) fließenden Spulenstroms (I) zu Einschaltzeitpunkten und Ausschaltzeitpunkten, die mit Hilfe eines Taktsignals (V3) vorgegeben werden,
   - Erzeugen eines PWM-Signals (out) mit einem für die Induktivität (L) der Messspule (2) repräsentativen Tastverhältnis, indem das PWM-Signal (out) mit steigenden und fallenden PWM-Signalflanken erzeugt wird,
   - die einerseits zeitgleich mit dem Einschalten oder mit dem Ausschalten des Spulenstroms (I) getriggert werden und andererseits getriggert werden, sobald ein Wert des Spulenstroms (I) eine vorgegebene Triggerschwelle (TRG) erreicht, oder
   - die beide jeweils getriggert werden, sobald ein Wert des Spulenstroms (I) eine vorgegebene Triggerschwelle (TRG) erreicht,
   - Auswerten des PWM-Signals (out), um dessen Tastverhältnis und daraus die Induktivität (L) der Messspule (2) zu ermitteln,

   wobei das Verfahren für eine Kompensation einer Temperaturabhängigkeit des Tastverhältnisses des PWM-Signals (out) aufgrund einer Temperaturabhängigkeit eines ohmschen Widerstands (R) der Messspule (2) ferner die Schritte umfasst:

   - Erfassen eines stationären maximalen Werts (Imax) des Spulenstroms (I) nach einem Einschalten und vor dem nachfolgenden Ausschalten des Spulenstroms (I),
   - Vorgeben der Triggerschwelle (TRG) in Abhängigkeit von dem erfassten stationären maximalen Wert (Imax) des Spulenstroms (I).

**2.** Verfahren nach Anspruch 1, wobei die Schritte zum Kompensieren der Temperaturabhängigkeit des Tastverhältnisses nach jedem Einschalten des Spulenstroms (I) durchgeführt werden.

**3.** Verfahren nach Anspruch 1, wobei die Schritte zum Kompensieren der Temperaturabhängigkeit des Tastverhältnisses nach jedem n-ten Einschalten des Spulenstroms (I) durchgeführt werden, wobei n eine ganze Zahl ist, die beispielsweise im Bereich von 2 bis 100 liegt.

**4.** Verfahren nach Anspruch 1, wobei die Durchführung der Schritte zum Kompensieren der Temperaturabhängigkeit des Tastverhältnisses bedarfsweise durch ein Steuersignal befehligt wird.

**5.** Verfahren nach einem der vorangehenden Ansprüche, wobei die Messspule (2) durch eine Wicklung aus metallischem Material oder durch eine Leiterbahn aus metallischem Material auf einer Schaltungsträgerplatte gebildet ist.

**6.** Verfahren nach einem der vorangehenden Ansprüche, wobei der Spulenstrom (I) über einen in Reihenschaltung zur Messspule (2) angeordneten Messwiderstand (R5, R6) geführt wird und die Erfassung des Werts des Spulenstroms (I) durch eine Erfassung einer am Messwiderstand (R5, R6) abfallenden Spannung (U1) realisiert wird.

**7.** Schaltungsanordnung (1) zur Ermittlung einer Induktivität (L) einer Messspule (2), aufweisend

    - eine Bestromungseinrichtung (10) zum Einschalten und Ausschalten eines durch die Messspule (2) fließenden Spulenstroms (I) zu Einschaltzeitpunkten und Ausschaltzeitpunkten, die mit Hilfe eines Taktsignals (V3) vorgegeben werden,
    - eine PWM-Signal-Erzeugungseinrichtung (20) zum Erzeugen eines PWM-Signals (out) mit einem für die Induktivität (L) der Messspule (2) repräsentativen Tastverhältnis, indem das PWM-Signal (out) mit steigenden und fallenden PWM-Signalflanken erzeugt wird,
    - die einerseits zeitgleich mit dem Einschalten oder mit dem Ausschalten des Spulenstroms (I) getriggert werden und andererseits getriggert werden, sobald ein Wert des Spulenstroms (I) eine vorgegebene Triggerschwelle (TRG) erreicht, oder
    - beide jeweils getriggert werden, sobald ein Wert des Spulenstroms (I) eine vorgegebene Triggerschwelle (TRG) erreicht, aufweisend
    - eine Triggervorgabeeinrichtung (22) zur Vorgabe der Triggerschwelle (TRG),
    - eine Erfassungs- und Vergleichseinrichtung

    (24) zum Erfassen eines Werts des Spulenstroms (I) und zum Vergleichen dieses Werts mit der vorgegebenen Triggerschwelle (TRG),
    - eine Auswerteeinrichtung (30) zum Auswerten des PWM-Signals (out), um dessen Tastverhältnis und daraus die Induktivität (L) der Messspule (2) zu ermitteln,

wobei die PWM-Signal-Erzeugungseinrichtung (20) für eine Kompensation einer Temperaturabhängigkeit des Tastverhältnisses des PWM-Signals (out) aufgrund einer Temperaturabhängigkeit eines ohmschen Widerstands (R) der Messspule (2) ferner aufweist:

    - eine Erfassungs- und Vorgabeaktualisierungseinrichtung (26) zum Erfassen eines stationären maximalen Werts (Imax) des Spulenstroms (I) nach einem Einschalten und vor dem nachfolgenden Ausschalten des Spulenstroms (I) und zum Vorgeben der Triggerschwelle (TRG) in Abhängigkeit von dem erfassten stationären maximalen Wert (Imax) des Spulenstroms (I).

**8.** Schaltungsanordnung (1) nach Anspruch 7, wobei die Erfassungs- und Vergleichseinrichtung (24) aufweist:

    - einen Messwiderstand (R5, R6), der bei der Ermittlung der Induktivität (L) der Messspule (2) in Reihenschaltung zur Messspule (2) angeordnet ist und über den der Spulenstrom (I) geführt wird,
    - einen Komparator (V1) zum Vergleichen einer am Messwiderstand (R5, R6) abfallenden Spannung (U1) mit einer als Triggerspannung (VTRG) vorgegebenen Triggerschwelle (TRG).

**9.** Schaltungsanordnung (1) nach Anspruch 8, wobei die Erfassungs- und Vorgabeaktualisierungseinrichtung (26) eine Abtast-Halte-Schaltung (SH) zum Abtasten und Halten einer am Messwiderstand (R5, R6) abfallenden Spannung (U2) aufweist.

**10.** Verwendung eines Verfahrens nach einem der Ansprüche 1 bis 6 und/oder einer Schaltungsanordnung (1) nach einem der Ansprüche 7 bis 9 zur Ermittlung einer Induktivität (L) einer Messspule (2) eines induktiven Sensors, insbesondere Positionssensors oder eines Winkelsensors.

**Claims**

**1.** Method for determining an inductance (L) of a measuring coil (2), comprising the steps of:

    - switching on and switching off a coil current (I) flowing through the measuring coil (2) at switch-on times and switch-off times that are specified by means of a clock signal (V3),

- generating a PWM signal (out) with a duty cycle that is representative of the inductance (L) of the measuring coil (2) by generating the PWM signal (out) with rising and falling PWM signal edges,
- which on the one hand are triggered at the same time as the switching on or switching off of the coil current (I) and on the other hand are triggered as soon as a value of the coil current (I) reaches a specified trigger threshold (TRG), or
- both of which are triggered as soon as a value of the coil current (I) reaches a specified trigger threshold (TRG),
- evaluating the PWM signal (out) in order to determine the duty cycle thereof and from this the inductance (L) of the measuring coil (2),

wherein, for compensation of a temperature dependency of the duty cycle of the PWM signal (out) due to a temperature dependency of an ohmic resistance (R) of the measuring coil (2), the method further comprises the steps of:

- detecting a steady-state maximum value (Imax) of the coil current (I) after switching on and before subsequently switching off the coil current (I),
- specifying the trigger threshold (TRG) depending on the detected steady-state maximum value (Imax) of the coil current (I).

2. Method according to Claim 1, wherein the steps to compensate for the temperature dependency of the duty cycle are carried out after each time the coil current (I) is switched on.

3. Method according to Claim 1, wherein the steps to compensate for the temperature dependency of the duty cycle are carried out after each nth time the coil current (I) is switched on, where n is an integer for example in the range of 2 to 100.

4. Method according to Claim 1, wherein the execution of the steps to compensate for the temperature dependency of the duty cycle is commanded by a control signal as required.

5. Method according to any one of the preceding claims, wherein the measuring coil (2) is formed by a winding made of metallic material or by a conductor track made of metallic material on a circuit carrier board.

6. Method according to any one of the preceding claims, wherein the coil current (I) is conducted via a measuring resistor (R5, R6) arranged in series with the measuring coil (2) and the detection of the value of the coil current (I) is realized by detecting a voltage (U1) dropping across the measuring resistor (R5, R6).

7. Circuit arrangement (1) for determining an inductance (L) of a measuring coil (2), comprising

- a current feed device (10) for switching on and switching off a coil current (I) flowing through the measuring coil (2) at switch-on times and switch-off times that are specified by means of a clock signal (V3),
- a PWM signal generating device (20) for generating a PWM signal (out) with a duty cycle that is representative of the inductance (L) of the measuring coil (2) by generating the PWM signal (out) with rising and falling PWM signal edges,
- which on the one hand are triggered at the same time as the switching on or switching off of the coil current (I) and on the other hand are triggered as soon as a value of the coil current (I) reaches a specified trigger threshold (TRG), or
- both are triggered as soon as a value of the coil current (I) reaches a specified trigger threshold (TRG), having
- a trigger specification device (22) for specifying the trigger threshold (TRG),
- a detection and comparison device (24) for detecting a value of the coil current (I) and for comparing this value with the specified trigger threshold (TRG),
- an evaluating device (30) for evaluating the PWM signal (out) in order to determine the duty cycle thereof and from this the inductance (L) of the measuring coil (2),

wherein, for compensation of a temperature dependency of the duty cycle of the PWM signal (out) due to a temperature dependency of an ohmic resistance (R) of the measuring coil (2), the PWM signal generating device (20) further comprises:

- a detection and specification update device (26) for detecting a steady-state maximum value (Imax) of the coil current (I) after switching on and before subsequently switching off the coil current (I) and for specifying the trigger threshold (TRG) depending on the detected steady-state maximum value (Imax) of the coil current (I).

8. Circuit arrangement (1) according to Claim 7, wherein the detection and comparison device (24) comprises:

- a measuring resistor (R5, R6) arranged in series with the measuring coil (2) when determining the inductance (L) of the measuring coil (2) and via which the coil current (I) is conducted,
- a comparator (V1) for comparing a voltage (U1) dropping across the measuring resistor (R5, R6) with a trigger threshold (TRG) specified as trigger voltage (VTRG) .

9.  Circuit arrangement (1) according to Claim 8, wherein the detection and specification update device (26) comprises a sample-and-hold circuit (SH) for sampling and holding a voltage (U2) dropping across the measuring resistor (R5, R6).

10. Use of a method according to any one of Claims 1 to 6 and/or a circuit arrangement (1) according to any one of Claims 7 to 9 for determining an inductance (L) of a measuring coil (2) of an inductive sensor, in particular a position sensor or an angle sensor.


**Revendications**

1.  Procédé de détermination de l'inductance (L) d'une bobine de mesure (2), comprenant les étapes suivantes :

    - mise en circuit et hors circuit d'un courant de bobine (I) qui circule à travers la bobine de mesure (2) à des instants de mise en circuit et de mise hors circuit qui sont prédéfinis à l'aide d'un signal d'horloge (V3),
    - génération d'un signal PWM (out) avec un rapport cyclique représentatif de l'inductance (L) de la bobine de mesure (2) en générant le signal PWM (out) avec des fronts de signal PWM ascendants et descendants,
    - qui sont déclenchés d'une part simultanément avec la mise en circuit ou avec la mise hors circuit du courant de bobine (I) et, d'autre part, dès qu'une valeur du courant de bobine (I) atteint un seuil de déclenchement (TRG) prédéfini, ou
    - qui sont tous deux déclenchés respectivement dès qu'une valeur du courant de bobine (I) atteint un seuil de déclenchement (TRG) prédéfini,
    - évaluation du signal PWM (out) afin d'en déterminer le rapport cyclique et, à partir de celui-ci, l'inductance (L) de la bobine de mesure (2),

    le procédé comprenant en outre, pour une compensation d'une dépendance à la température du rapport cyclique du signal PWM (out) en raison d'une dépendance à la température d'une résistance ohmique (R) de la bobine de mesure (2), les étapes suivantes :

    - détection d'une valeur maximale (Imax) fixe du courant de bobine (I) après la mise en circuit et avant la mise hors circuit ultérieure du courant de bobine (I),
    - prédéfinition du seuil de déclenchement (TRG) en fonction de la valeur maximale (Imax) fixe détectée du courant de bobine (I).

2.  Procédé selon la revendication 1, les étapes de compensation de la dépendance à la température du rapport cyclique étant exécutées après chaque mise en circuit du courant de bobine (I).

3.  Procédé selon la revendication 1, les étapes de compensation de la dépendance à la température du rapport cyclique étant exécutées après chaque n-ième mise en circuit du courant de bobine (I), n étant un nombre entier qui se situe, par exemple, dans la plage de 2 à 100.

4.  Procédé selon la revendication 1, l'exécution des étapes de compensation de la dépendance à la température du rapport cyclique étant contrôlée, en cas de besoin, par un signal de commande.

5.  Procédé selon l'une des revendications précédentes, la bobine de mesure (2) étant formée par un enroulement en matériau métallique ou par une piste conductrice en matériau métallique sur une plaque support de circuit.

6.  Procédé selon l'une des revendications précédentes, le courant de bobine (I) étant conduit par une résistance de mesure (R5, R6) montée en série avec la bobine de mesure (2) et la détection de la valeur du courant de bobine (I) étant réalisée par détection d'une tension de chute (U1) aux bornes de la résistance de mesure (R5, R6).

7.  Arrangement de circuit (1) destiné à déterminer une inductance (L) d'une bobine de mesure (2), possédant

    - un dispositif d'alimentation électrique (10) destiné à mettre en circuit et hors circuit un courant de bobine (I) qui circule à travers la bobine de mesure (2) à des instants de mise en circuit et de mise hors circuit qui sont prédéfinis à l'aide d'un signal d'horloge (V3),
    - un dispositif de génération de signal PWM (20) destiné à générer un signal PWM (out) avec un rapport cyclique représentatif de l'inductance (L) de la bobine de mesure (2) en générant le signal PWM (out) avec des fronts de signal PWM ascendants et descendants,
    - qui sont déclenchés d'une part simultanément avec la mise en circuit ou avec la mise hors circuit du courant de bobine (I) et, d'autre part, dès qu'une valeur du courant de bobine (I) atteint un seuil de déclenchement (TRG) prédéfini, ou

- qui sont tous deux déclenchés respectivement dès qu'une valeur du courant de bobine (I) atteint un seuil de déclenchement (TRG) prédéfini, possédant

- un dispositif de prédéfinition de déclenchement (22) destiné à prédéfinir le seuil de déclenchement (TRG),

- un dispositif de détection et de comparaison (24) destiné à détecter une valeur du courant de bobine (I) et destiné à comparer cette valeur avec le seuil de déclenchement (TRG) prédéfini,

- un dispositif d'évaluation (30) destiné à évaluer le signal PWM (out) afin d'en déterminer le rapport cyclique et, à partir de celui-ci, l'inductance (L) de la bobine de mesure (2),

le dispositif de génération de signal PWM (20) possédant en outre, pour une compensation d'une dépendance à la température du rapport cyclique du signal PWM (out) en raison d'une dépendance à la température d'une résistance ohmique (R) de la bobine de mesure (2) :

- un dispositif de détection et de mise à jour de prédéfinition (26) destiné à détecter une valeur maximale (Imax) fixe du courant de bobine (I) après la mise en circuit et avant la mise hors circuit ultérieure du courant de bobine (I) et destiné à prédéfinir le seuil de déclenchement (TRG) en fonction de la valeur maximale (Imax) fixe détectée du courant de bobine (I).

8. Arrangement de circuit (1) selon la revendication 7, le dispositif de détection et de comparaison (24) possédant :

- une résistance de mesure (R5, R6) qui, lors de la détermination de l'inductance (L) de la bobine de mesure (2), est montée en série avec la bobine de mesure (2) et par laquelle est conduit le courant de bobine (I),

- un comparateur (V1) destiné à comparer une tension de chute (U1) aux bornes de la résistance de mesure (R5, R6) avec un seuil de déclenchement (TRG) prédéfini comme tension de déclenchement (VTRG).

9. Arrangement de circuit (1) selon la revendication 8, le dispositif de détection et de mise à jour de prédéfinition (26) possédant un circuit échantillonneur-bloqueur (SH) destiné à échantillonner et maintenir une tension de chute (U2) aux bornes de la résistance de mesure (R5, R6).

10. Utilisation d'un procédé selon l'une des revendications 1 à 6 et/ou d'un arrangement de circuit (1) selon l'une des revendications 7 à 9 pour déterminer une inductance (L) d'une bobine de mesure (2) d'un capteur inductif, notamment d'un capteur de position ou d'un capteur angulaire.

# FIG 1

EP 4 483 142 B1

FIG 2

# FIG 3

EP 4 483 142 B1

FIG 4

EP 4 483 142 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 4120861 C2
- DE 4304061 B4

- DE 4204060 A1